# EUROPEAN PATENT APPLICATION

(11) **EP 3 553 834 A1**
(43) Date of publication of application: **16.10.2019**
(21) Application number: 17877825.4
(22) Date of filing: 20.10.2017
(51) Int. Cl.: H01L 31/12

(54) **ISOLATION AMPLIFIER**

(30) Priority: 06.12.2016 JP 2016236474
(71) Applicant: NTN Corporation, Osaka-shi, Osaka 550-0003 (JP)
(72) Inventor: HANEDA Masaji, Omihachiman-shi Shiga 521-0351 (JP)
(74) Representative: Müller, Enno
(86) International application number: PCT/JP2017/038067
(87) International publication number: WO 2018/105253

(57) **Abstract**

To improve a linearity of the input signal and the output signal without using an amplifier.

A current Iin is separated into a current I1 and a current 12. When the current I1 flows in a light emitting diode D1, the light emitting diode D1 emits light and the current path of a phototransistor Q1 becomes conductive. At that time, a current lout flows in a light emitting diode D2. When the light emitting diode D2 emits light, the current path of a phototransistor Q2 becomes conductive, and the current I2 flows. If the value of the current lout is exceedingly large, the light emitting strength of the light emitting diode D2 is also exceedingly large. At that time, a large current I2 flows in the phototransistor Q2, which decreases the value of the current I1 flowing in the light emitting diode D1. As a result, the light emitting strength of the light emitting diode D1 becomes small, and the value of the current lout decreases. In this manner, since a photocoupler P2 functions as a negative feedback circuit, a linearity of the current Iin and the current lout improves.

## Description

### TECHNICAL FIELD

The invention relates to an isolation amplifier in which the input terminal and the output terminal are insulated.

### BACKGROUND ART

A photocoupler is capable of transmitting a signal between the input terminal and the output terminal even those terminals are insulated electronically. Usually, however, the input signal and the output signal of the photocoupler are not in a proportionate relationship, and for instance, even when the input signal changes linearly, the output signal does not change linearly. This does not cause a problem when using a photocoupler as a switching element. However, in the case that a high linearity of the input signal and the output signal is required, a photocoupler cannot be used alone.

Patent Literature 1 discloses an isolation amplifier which has improved a linearity of the input signal and the output signal using two photocouplers and a negative feedback amplifier. In this isolation amplifier, a first photocoupler outputs an electric current in accordance with the input current input by the input terminal. A second photocoupler outputs an electric current in accordance with the output current output by the output terminal. In the negative feedback amplifier, an electric voltage in accordance with the output current of the first photocoupler is to be input in the positive input terminal, and an electric voltage in accordance with the output current of the second photocoupler is to be input in the negative input terminal, and then, it outputs the output current from the output terminal, which equalizes the values of those voltage. The output terminal of the negative feedback amplifier is connected to the output terminal, and the output current output from the output terminal of the negative feedback amplifier is to be output from the output terminal. If features of the two photocouplers are similar, the input current and the output current of the isolation amplifier are proportional.

### PRIOR ART LITERATURE

### <Patent Literature>

Patent Literature 1: Japanese Unexamined Patent Application Publication No. Sho 49-009955

### BRIEF SUMMARY OF THE INVENTION

### <Problems to be Solved by the Invention>

The isolation amplifier disclosed in Patent Literature 1 includes an amplifier.

The purpose of the present invention is to provide an isolation amplifier capable of improving the linearity of the input signal and output signal without using an amplifier.

### <Means to Solve the Problems>

In order to achieve the above-stated purpose, an isolation amplifier of the present invention is characterized by:
comprising a first and a second light coupling elements which include a light emitting element which emits light in accordance with the current flowing and a light receiving element which carries a current in line with the strength of the light generated by the light emitting element;
the light emitting element included in the first light coupling element and the light receiving element included in the second light coupling element are connected in parallel;
the light receiving element included in the first light coupling element and the light emitting element included in the second light coupling element are connected in series, and;
when a current is input into the circuit comprised of the light emitting element and the light receiving element connected in parallel, a current flowing in the circuit comprised of the light emitting element and the light receiving element connected in series, or a voltage in accordance therewith is output.

### EFFECTS OF THE INVENTION

According to the present invention, without using an amplifier, the linearity of the input signal and output signal can be improved.

### BRIEF DESCRIPTION OF THE DRAWINGS

Fig. 1 shows an example of a configuration of an isolation amplifier according to the embodiment of the present invention.
Fig. 2 shows a configuration of the isolation amplifier, which is an example of a modification of the isolation amplifier indicated in Fig. 1.

### EMBODIMENT FOR THE INVENTION

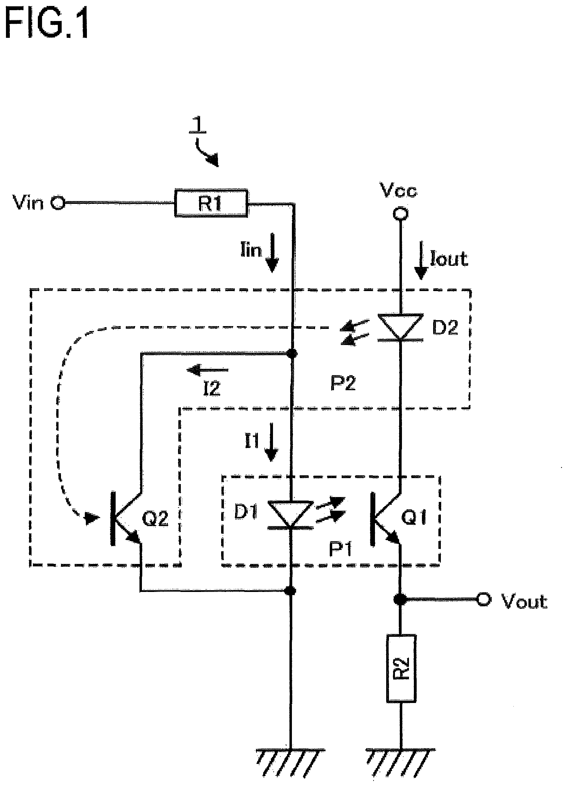

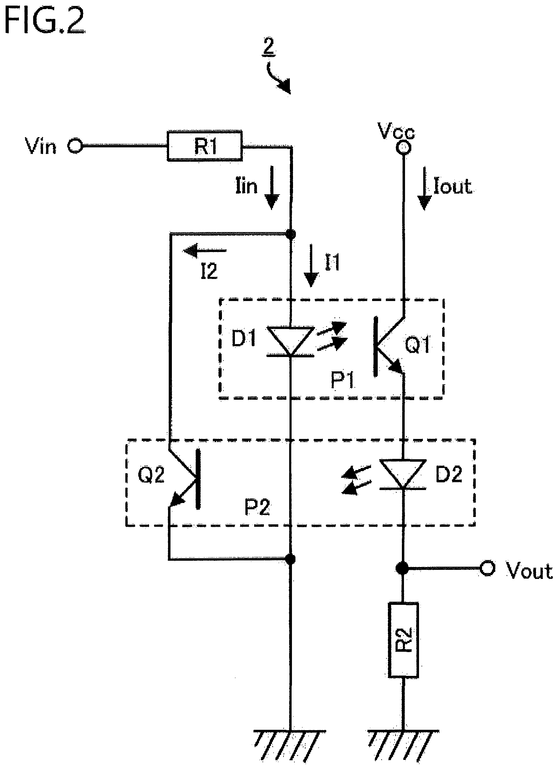

Referring to the drawings, detailed explanations are given below on the isolation amplifier according to the embodiment of the present invention. In Fig. 1 and Fig. 2, which explain the embodiment, the same prefix is added for the common configuration elements so that repetitive explanations can be omitted.

Fig. 1 shows an example of the configuration of an isolation amplifier according to the embodiment of the present invention.

An isolation amplifier 1 has a photocoupler P1, which is a first light coupling element; a photocoupler P2, which is a second light coupling element; a resistance R1; and a resistance R2.

The photocoupler P1 includes a light emitting diode D1, which is a light emitting element; and a phototransistor Q1, which is a light receiving element. In the same manner, the photocoupler P2 includes a light emitting diode D2, which is a light emitting element; and a phototransistor Q2, which is a light receiving element. It is preferable that characteristics of the photocoupler P1 and the photocoupler P2 are the same, however, it is acceptable that if they have similar characteristics. In the case that they have similar characteristics, note that it will be necessary to have an amplifier.

An input terminal Vin is connected to a terminal of the resistance R1. One terminal of the resistance R1 is connected to the input terminal Vin, and the other terminal is connected to an anode of the light emitting diode D1, and a collector of the phototransistor Q2.

The anode of the light emitting diode D1 is connected to the other terminal of the resistance R1, and a cathode of which is grounded. As for the phototransistor Q2, its collector is connected to the other terminal of the resistance R1, and the emitter is grounded. That is, the light emitting diode D1 and the phototransistor Q2 are connected in parallel.

For the light emitting diode D2, the power-supply voltage Vcc is applied to its anode, and its cathode is connected to the collector of the phototransistor Q1. As regards the phototransistor Q1, its collector is connected to the cathode of the light emitting diode D2 and its emitter is connected to one terminal of the resistance R2. That is, the light emitting diode D2 and the phototransistor Q1 are connected in series.

For the resistance R2, one terminal of the resistance R2 is connected to the emitter of the phototransistor Q1, and the other terminal is grounded.

An output terminal Vout is connected to the connected point between the emitter of the phototransistor Q1 and one terminal of the resistance R2.

Next, operations of the isolation amplifier 1 are explained below.

When the voltage is applied to the input terminal Vin, a current Iin flows into the circuit where the light emitting diode D1 and the phototransistor Q2 are connected in parallel, via the resistance R1.

The current Iin is separated into a current I1 and a current 12. The current I1 flows in the light emitting diode D1. When the current I1 flows in the light emitting diode D1, the light emitting diode D1 emits light and a current path of the phototransistor Q1 becomes conductive. At that time, a current lout flows in the circuit where the light emitting diode D2 and phototransistor Q1 are connected in series. When the current lout flows, a voltage is generated in the resistance R2, and the voltage is output from the output terminal Vout. Also, when the current lout flows, the light emitting diode D2 emits light and a current path of the phototransistor Q2 becomes conductive and then, the current I2 flows.

The photocoupler P2 functions as a negative feedback circuit.

When the value of the current lout is exceedingly large, the light emitting strength of the light emitting diode D2 is also exceedingly large. At that time, a large current I2 flows in the phototransistor Q2, which in turn decreases the current I1 flowing in the light emitting diode D1. As a result, the light emitting strength of the light emitting diode D1 becomes small, and the value of the current lout decreases.

Conversely, when the value of the current lout is exceedingly small, the light emitting strength of the light emitting diode D2 is also exceedingly small. At that time, a small current I2 flows in the phototransistor Q2, which in turn increases the value of the current I1 flowing in the light emitting diode D1. As a result, the light emitting strength of the light emitting diode D1 becomes large, and the value of the current lout increases.

As explained above, with the photocoupler P2 functioning as a negative feedback circuit, a linearity of the voltage applied to the input terminal Vin, and the voltage output from the output terminal Vout (the current Iin and the current Iout) is improved.

Fig. 2 shows a configuration of an isolation amplifier 2, which is an example of a different form of the isolation amplifier 1.

The isolation amplifier 2 is different from the isolation amplifier 1 in the point that the connection order of the light emitting diode D2 and the phototransistor Q1 connected in series. In other words, in the phototransistor Q1, the power-supply voltage Vcc is applied in the collector, and the emitter is connected to the anode of the light emitting diode D2. In the light emitting diode D2, the anode is connected to the emitter of the phototransistor Q1, and the cathode is connected to one terminal of the resistance R2, and the output terminal Vout.

For the points and operations other than the above, the isolation amplifier 1 and the isolation amplifier 2 are the same.

In the embodiment explained above, a photocoupler which includes the light emitting diode and the phototransistor as an example of light coupling element. Not only that, for a case of a light coupling element which includes a light emitting element which emits light in accordance with the current flowing, and a light receiving element which carries the current in accordance with the light strength generated from that light emitting element, that can be used as a light coupling element according to the present invention.

Further, the embodiment explained above shows an example of the configuration in which the voltage is applied in the input terminal Vin, and the current Iin flows via the resistance R1. Alternatively, a configuration in which the current Iin is input into the input terminal from the outside current source without using the resistance R1 may be used.

Further, in the embodiment explained above, an example of the configuration is shown wherein when the current lout flows the resistance R2, the voltage is applied in the resistance R2, and the voltage is output from the output terminal Vout. Alternatively, a configuration may be used wherein the current lout is output from the output terminal to the outside load without using the resistance R2.

As explained above, according to this invention, the linearity of the input signal and the output signal can be improved without using an amplifier.

The embodiment of the present invention has been explained above. Various modifications and combinations to be required in manufacturing or due to other factors are included in the invention defined in the claim, and in the scope of the invention corresponding to specific examples described in the embodiment of the invention.

### [Reference Numerals]

- 1, 2: Isolation amplifier
- P1: Photocoupler
- D1: Light emitting diode of photocoupler P1
- Q1: Phototransistor of photocoupler P1
- P2: Photocoupler
- D1: Light emitting diode of photocoupler P2
- Q2: Phototransistor of photocoupler P2
- R1, R2: Resistance

## Claims

1. An isolation amplifier **characterized by**:
comprising a first and a second light coupling elements which include a light emitting element which emits light in accordance with a current flowing, and a light receiving element which carries a current in accordance with the light strength generated from the light emitting element;
the light emitting element included in the first light coupling element and the light receiving element included in the second light coupling element are connected in parallel;
the light receiving element included in the first light coupling element and the light emitting element included in the second light coupling element are connected in series; and
when a current is input into the circuit comprised of the light emitting element and the light receiving element connected in parallel, a current flowing in the circuit comprised of the light emitting element and the light receiving element connected in series, or a voltage in accordance therewith is output.
